## Europäisches Patentamt

## European Patent Office

## Office européen des brevets

(11) Publication number: **0 188 769**
A2

# (12) EUROPEAN PATENT APPLICATION

(21) Application number: 85116206.5

(22) Date of filing: 20.12.85

(51) Int. Cl.⁴: **G 11 C 11/24**, G 11 C 8/00

(30) Priority: 25.12.84 JP 275554/84

(43) Date of publication of application: 30.07.86
Bulletin 86/31

(84) Designated Contracting States: DE FR GB

(71) Applicant: FUJITSU LIMITED, 1015, Kamikodanaka
Nakahara-ku, Kawasaki-shi Kanagawa 211 (JP)

(72) Inventor: Takemae, Yoshihiro, 8-13-24-303, Akasaka
Minato-ku, Tokyo 107 (JP)
Inventor: Mochizuki, Hirohiko, 2393-1-401, Arima
Miyamae-ku, Kawasaki-shi Kanagawa 213 (JP)

(74) Representative: Seeger, Wolfgang, Dipl.-Phys.,
European Patent Attorney Bereiteranger 15,
D-8000 München 90 (DE)

(54) Dynamic type semiconductor memory device.

(57) In a dynamic type semiconductor memory device, a shift resistor holds data including only one at «1» and remaining stages are all at «0». The data is circulated and selects a word line sequentially by the «1» output of the data to carry out a refresh operation for the memory device. A set up circuit, when an output of a specified stage of the shift register is «1», makes all outputs of remaining stages «0», and when all outputs of all stages of the shift register are «0», makes an output of a specified stage of the register «1».

EP 0 188 769 A2

# DYNAMIC TYPE SEMICONDUCTOR MEMORY DEVICE

BACKGROUND OF THE INVENTION

1.    Field of the Invention

The present invention relates to a dynamic type semiconductor memory device in which a word line to be refreshed is selected by a shift register and when a power source is switched ON, only one bit of the shift register is used to select the output for selecting the word line.

2.    Description of the Related Arts

A dynamic type random access memory (RAM) requires periodical refreshing to prevent the disappearance of cell information.  During this refreshing, all word lines of the memory are sequentially selected one by one, and all memory cells belonging to the selected word line are refreshed.  That is, this refreshing is carried out by a method in which stored cell charges corresponding to data "0" and "1" are returned to a correct value when data is written.  For selecting the word line to be refreshed, conventionally, an address counter is used.  Namely, an address counter counts clocks and generates an address which sequentially selects the word lines, and this address is input to usual access system for the word line.  However, this has a drawback in that the operation becomes very complicated.

For removing the drawback mentioned above, a device which provides a shift register having an input and output which is used exclusively for refreshing by sequentially selecting the word lines, has been proposed by the same applicant in United State Patent Application Serial No. 648,506.  The shift register has an input and an output connected to each other and operates in like a manner as a ring counter.

In the device mentioned above, the refresh operation can be performed without applying any refresh address information to the device from the exterior as in the device including a refresh address counter. In addition, as the shift register has a simple circuit configuration as compared to the ordinary refresh address counter, it has an advantage in that each stage of the shift register can be laid out between word lines having a narrow pitch when formed as an integrated circuit. However, when more than two bits of the data held in the shift register are at "1", the word lines are multi-selected and the cell information is destroyed. Further, when the bits are all "0", the word line is not selected and refreshing is not carried out normally. Despite such potential malfunctions, each stage of the shift register is in an unstable state when the power source is switched ON, and a plurality of bits may become "1" or all of the bits may become "0". These data are maintained as long as the power source is kept in ON state, and thus, the malfunctions explained above may occur.

SUMMARY OF THE INVENTION

An object of the present invention is to provide a dynamic type semiconductor memory device having a shift register in which only one bit becomes "1" (selection level).

In a dynamic type semiconductor memory device, a shift register holds data including only one bit at "1" and the remainder of the bits are at "0". The data is circulated and sequentially selects only one word line at a time by a "1" output of the data to refresh the memory device. A set up circuit, when an output of a specified stage of the shift register is "1", makes all outputs of remaining stages "0", and when all outputs of all stages of the shift register are "0", makes an output of a specified stage of the register "1".

According to the present invention, only one bit of the stages of the shift register is set at "1" and all the remaining stages are set at "0" at least after one complete cycle of the data shift all around the stages even if plural stages have been set at "1" due to instability of the device immediately after the power ON. The one complete cycle of the data shift may be conducted as a warming-up operation after power ON, and thus, the malfunction in which the outputs of all stages are "0", none of the word lines are selected or refreshing, or plural word lines are selected at a time, can be prevented.

Further features and advantages of the present invention will be apparent from the ensuing description with reference to the accompanying drawings to which, however, the scope of the invention is in no way limited.

BRIEF DESCRIPTION OF THE DRAWINGS

Figure 1 is a diagram showing the outline of one example of a conventional dynamic RAM;

Fig. 2 is a circuit diagram of a shift register shown in Fig. 1;

Fig. 3 is a diagram showing an outline of one embodiment of the RAM according to the present invention;

Fig. 4 is a diagram explaining the principle of the operation of the present application; and

Fig. 5 is a diagram showing one embodiment of a set up circuit according to the present invention.

DESCRIPTION OF THE PREFERRED EMBODIMENTS

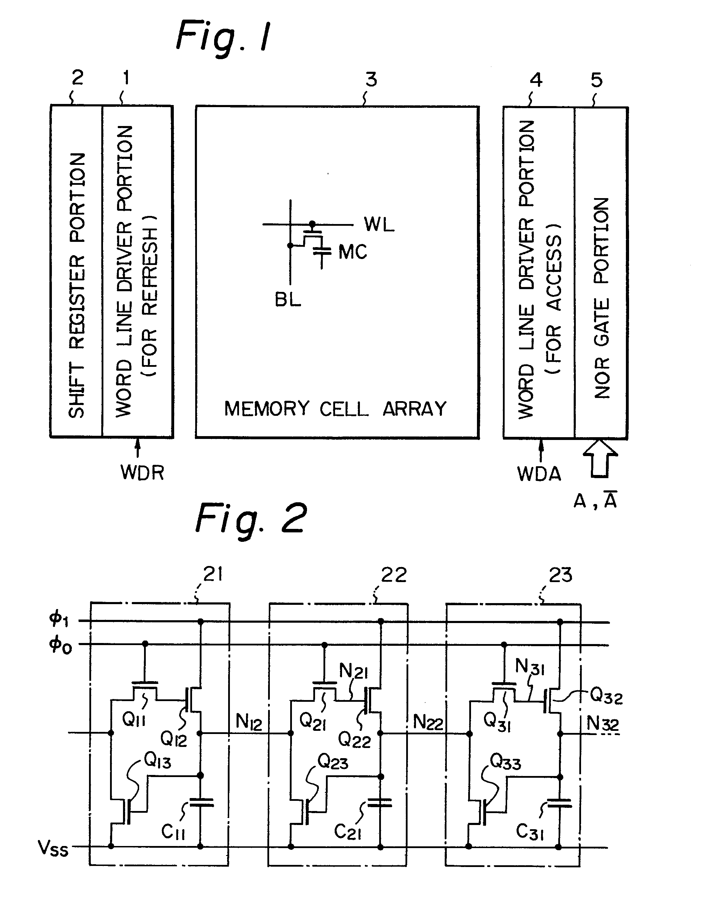

Figure 1 is a diagram showing an outline of one example of a dynamic RAM according to the prior art.

The dynmic RAM shown in Fig. 1 includes a word line driver portion 1 used exclusively for a refresh operation, and a shift register portion 2 which sequentially indicates the word lines which are selected in the driver portion 1, reference numeral 3 designates a memory cell array in which dynamic type memory cells MC (only one example is shown in the drawing and is a one transistor-one capacitor type) are connected at cross points between a plurality of word lines WL and a plurality of bit lines BL, reference numeral 4 designates

- 4 -

0188769

another word line driver portion usually used for access, and reference numeral 5 designates a NOR gate portion which decodes external addresses A, $\bar{A}$ for usual addresses (via the address buffer) and which makes the driver portion 4 select one word line WL. The operation timings of the two driver portions 1 and 4 are controlled by exclusive signals WDR, WDA, so that the two driving portions are not operated at the same time.

A shift register portion 2 has the same number of stages as that of the word lines WL, wherein only one stage holds data "1" and the remaining stages hold data "0". This data is circulated and the data "1" sequentially selects the word lines. Namely, the output of data "1" sequentially brings the word lines to a selection level via the driving portion 1. Figure 2 shows a concrete example of this shift register portion, wherein 21, 22, 23, ... represent shift registers of each of the stages. The shift registers 21, 22, 23, ... of each stage are formed by three transistors $Q_{i1} \sim Q_{i3}$ and one capacitor $C_{i1}$ (i = 1, 2, 3, ...) and are operated by receiving two clocks $\phi_0$ , $\phi_1$. The clocks $\phi_0$ , $\phi_1$ are of opposite polarities, that is, when one clock is at the H (power source $V_{CC}$) level, the other is at the L (power source $V_{SS} - 2V_{th}$) level.

Hereinafter an explanation is given of the operation of the shift register stage 22. When the output $N_{12}$ of the former stage 21 is at the H level, if the clock $\phi_0$ rises to $V_{CC}$ , the transistor $Q_{21}$ is turned ON, so that the node $N_{21}$ is brought to the H (high) level. Thereafter, when the clock $\phi_0$ decreases to $V_{SS} + 2V_{th}$ ($V_{th}$ is a threshold voltage of each transistor), the transistor $Q_{21}$ turns OFF, the node $N_{21}$ holds the H level, and as the clock $\phi_1$ rises to $V_{CC}$ , the transistor $Q_{22}$ turns ON, so that the node $N_{22}$ is brought to the H level and the capacitor $C_{21}$ is charged up. When the voltage of the capacitor $C_{21}$ becomes higher than $V_{th}$ , the transistor $Q_{23}$ turns ON. When the transistor $Q_{23}$ turns

ON, charges in the capacitor $C_{11}$ in the former stage are discharged, so that the level of the node $N_{12}$ is lowered. When the level of this node $N_{12}$ decreases and reaches $V_{SS} + V_{th}$ , as the level of clock $\phi_0$ is $V_{SS} + 2V_{th}$ , the transistor turns ON again, so that charges in the node $N_{21}$ are discharged via the transistor $Q_{23}$. As a result, the transistor $Q_{22}$ turns OFF, the node $N_{22}$ is brought to the H level and the node $N_{12}$ is brought to the L level, and thus one shift operation is completed. That is, the capacitor $C_{11}$ of the former stage is discharged so that the data becomes 0, and at the same time, the capacitor $C_{21}$ of the own stage is charged so that the data becomes "1". Accordingly, the data "1" is shifted by only one stage of the register. This operation is repeated and the data "1" is sequentially shifted at each stage, so that the word lines are selected sequentially one by one. Furthermore, the output stage of the shift register is coupled to the input stage so that the data shift can be cyclically repeated.

In the latter half of the shift cycle mentioned above ($\phi_0 = V_{SS} + 2V_{th}$ , $\phi_1 = V_{CC}$), the node $N_{22}$ is brought to the H level, but this is not written in the shift register 23 of the following stage. That is, at this time, as the clock $\phi_0$ is at the L level, the transistor $Q_{31}$ is OFF, the node $N_{31}$ is at the L level, and therefore, the transistor $Q_{32}$ is OFF, thus the capacitor $C_{31}$ is not charged. However, this operation is based on the premise that the output $N_{22}$ of the shift register 22 in a former cycle is "0".

Each stage of the above-mentioned shift register portion 2 has a simple circuit configuration, therefore, it has an advantage in that it can be laid out between word lines having a narrow pitch when it is formed as an integrated circuit. However, when more than two bits of the data held in the shift register are at "1", the word lines are multi-selected and the cell information is destroyed. Further, when the bits are all "0", the word line is not selected and refreshing is not carried out usually, each stage of the shift register is in an unstable state when the power source is switched ON, and a plurality of bits may become "1" or all of the bits may become "0".

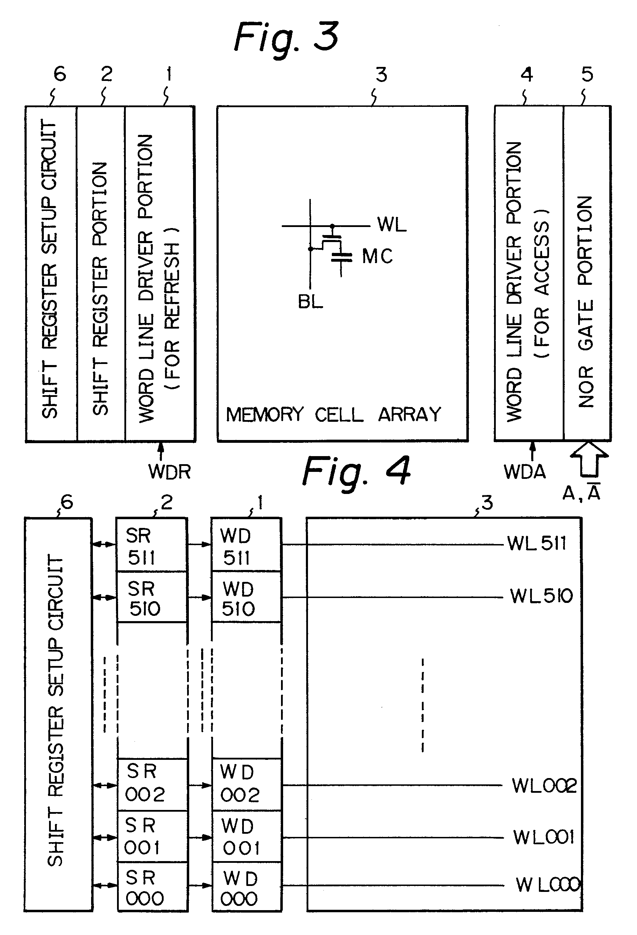

Figure 3 is a block diagram showing an outline of the present invention, in which a set up circuit 6 is added to the circuit shown in Fig. 1. Figure 4 is a detailed diagram showing an essential portion of the embodiment of Fig. 3 including this set up circuit 6. Namely, Fig. 4 shows a case wherein, as an example, the cell array 3 holds a total of 512 word lines from $WL_0$ to $WL_{511}$. The word line driver portion 1 and the shift register portion 2 are also formed in the 512 stage construction so as to correspond to the number of word lines. In Fig. 4, WD shows each stage of the word drivers and SR shows each stage of the shift registers. In Fig. 4, when the specified stage of the set up circuit 6, for example, an output of $SR_{000}$ is "1" (selection level), the $SR_{000}$ output of "1" is used as a reset signal RST to reset the remaining stages from $SR_1$ to $SR_{511}$ and the outputs thereat are made "0" (nonselection level). When the outputs of all stages of the shift registers 2 are "0", the set up circuit 6 makes the output of the specified stage $SR_{000}$ (or another specified stage such as $SR_{002}$) "1". The first function may be repeated every time the output of the specified stage $SR_{000}$ becomes "1", then this function may be added. The second function, whereby the outputs of all stages of the shift registers become "0", occurs only during a special state such as the switch ON time for the power source and does not occur in a steady state. Therefore, this function also may be added.

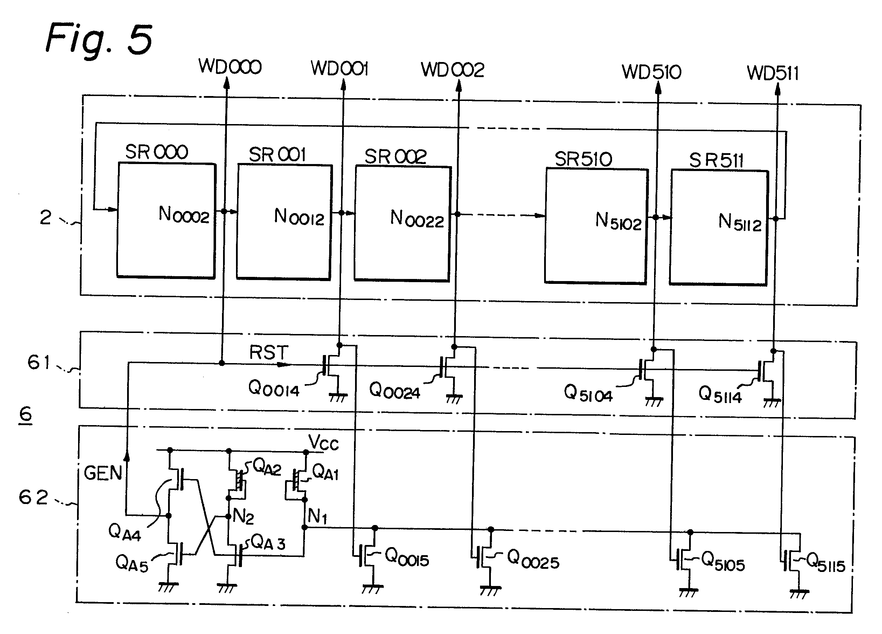

Figure 5 shows one embodiment of the present invention which is applied to the shift register shown in Fig. 1. In Fig. 5, the stages $SR_{000}$ ∿ $SR_{511}$ corre-

spond to those shown in Fig. 4 and the construction thereof is the same as the stages 21 to 23 shown in Fig. 2. The outputs of the stages $SR_{000}$ to $SR_{511}$ are connected to the word drivers $WD_{000}$ to $WD_{511}$ as shown in Fig. 4. The output $N_{5112}$ of the last stage $SR_{511}$ is fed back to the input of the initial $SR_{000}$ to form a ring counter.

The set up circuit 6 is formed by a reset portion 61 and a selection level generating portion 62. As shown in Fig. 5, in the reset portion 61, transistors $Q_{0014}$, $Q_{0024}$, $\cdots$ $Q_{5104}$, $Q_{5114}$ are connected between the outputs $N_{0012}$, $N_{0022}$, $\cdots$ $N_{5102}$, $N_{5112}$ and the ground. The output $N_{0002}$ of the special stage $SR_{000}$ is connected to the gates of the transistors $Q_{0014}$, $\cdots$, $Q_{5114}$. Therefore, when the output $N_{0002}$ of the stage $SR_{000}$ turns ON, the transistors $Q_{0014}$, $\cdots$, $Q_{5114}$ also turn ON, so that the outputs $N_{0012}$, $N_{0022}$, $\cdots$, $N_{5102}$, $N_{5112}$ except $N_{0002}$ are made "0". Concretely, this means that the charges of the capacitors $C_{11}$, $C_{21}$, $\cdots$ shown in Fig. 2 are forcibly pulled out by the transistors $Q_{0014}$, $\cdots$ $Q_{5114}$.

In the selection level generating portion 62, the gates of transistor $Q_{0015}$, $Q_{0025}$, $\cdots$, $Q_{5105}$, $Q_{5115}$ are connected the outputs $N_{0012}$, $N_{0022}$, $\cdots$ $N_{5102}$, $N_{5112}$, the drains thereof being connected as a node $N_1$, and the sources connected to ground. The transistors $Q_{0015}$ to $Q_{5115}$ form a NOR gate and a depletion type transistor $Q_{A1}$ is used as a load thereof. A depletion type transistor $Q_{A2}$ and the transistor $Q_{A3}$ form an inverter, and the output of the NOR gate is connected to the gate of the transistor $Q_{A3}$. The transistors $Q_{A4}$ and $Q_{A5}$ form a push-pull amplifier and the output of the inverter is connected to the gate of the transistor $Q_{A5}$ and the gate of the transistor $Q_{A4}$ receives the output of the NOR gate. The output of the push-pull transistor is connected to the output $N_{0002}$ of the specified stage $SR_{000}$.

The selection level generator circuit 62 shown in Fig. 5 prevents the output $N_{0002}$ of the initial stage $SR_{000}$ from becoming "0" when the outputs $N_{0002} \sim N_{5112}$ of the shift register 2 are all "0". That is, when the outputs $N_{0012} \sim N_{5112}$ all become "0", the transistors $Q_{015} \sim Q_{635}$ of the NOR gate having the transistor $Q_{A1}$ as a load all become OFF, so that the output $N_1$ is brought to a high level H. Transistors $Q_{A2}$, $Q_{A3}$ form an inverter which inverts this output $N_1$, and the inverted output $N_2$ and the gate output $N_1$ drive output stage push-pull transistors $Q_{A4}$, $Q_{A5}$. Therefore, when the output $N_1$ of the NOR gate is brought to the H level, the output GEN of the selection level generator circuit 62 is also brought to the H level, so that the output $N_{0002}$ of the initial stage $SR_{000}$ is forcibly made "1". Concretely, this means that a forcible charge up is carried out via a capacitor (for example, $C_{11}$) and a transistor $Q_{A4}$ shown in Fig. 2. At this time, as the transistor $Q_{0014} \sim Q_{5114}$ turns ON, then the outputs of all stages except for the initial stage are made "0".

Although the output $N_{0002}$ of the initial stage $SR_{000}$ does not always become "1" when the power source is switched ON, however, the shift operation is commenced when the power source is raised. Accordingly, the output of any stage becomes "1", and the output $N_{0002}$ of the initial stage eventually becomes "1", so that the circuit 61 is operated. Up to this point, the outputs of the plurality of stages may be "1", however, as the data is not written in the RAM at this time, no problem arises.

In the above-mentioned explanation, the initial stage $SR_{000}$ is taken as the specified stage. However, the specified stage is not limited to the initial stage, i.e., the speciffied stage for the reset circuit 61 may be different from that for the selection level generator circuit 62.

As explained above, according to the present invention, the operation is automatically set up in such a manner that only one bit of the content of the shift register for refreshing is brought to the selection level. Accordingly, destruction of the data due to the multi-selection of the word lines at the following refreshing operation can be prevented, and also the problem in which refreshing is not carried out because the word line is not selected when the data held in the shift register is all "0" does not arise.

## CLAIMS

1. A dynamic type semiconductor memory device having a shift register which holds data including only one at "1" and remaining stages are at "0", circulates said data, and which selects a word line sequentially by a "1" output of said data to carry out a refresh operation for said memory device, comprising a set up circuit including a first means which, when an output of a specified stage of said shift register is "1", makes all outputs of said remaining stages "0", and, a second means which, when all outputs of all stages of said shift register are "0", makes an output of a specified stage of said register "1".

2. A dynamic type semiconductor memory device according to claim 1 wherein said first means is formed by transistors connected between the outputs of said remaining stages and ground, and gates of said transistors are connected to the output of said specified stage.

3. A dynamic type semiconductor memory device according to claim 1, wherein said second means is formed by transistors each having a gate connected to the output of a stage except for said specified stage, a source connected to ground and a drain commonly connected to a load so as to form a NOR gate, and a driving means for driving said specified stage.

4. A dynamic type semiconductor memory device according to claim 3, wherein said driving means is formed by an inverter connected to the load of said NOR gate and a push-pull circuit is connected between the output of said inverter and the output of said specified stage.

5. A dynamic type semiconductor memory device according to any one of claims 1 to 4, wherein a specified stage in said first means is the same as that of said second means.

6. A dynamic type semiconductor memory device according to any one of claims 1 to 4, wherein a specified stage in said first means is different from that of said second means.

7. A shift register circuit for cyclically shifting a plurality of data bits consisting of a single bit of "1" and the remaining bit of "0", comprising:

a first shift register stage having an input and an output;

a plurality of second shift register stages in cascade connection, each of said second shift register stages having an input and an output, the output of said first shift register stage being connected to the input of the initial stage of said second shift register stages, the input of said first shift register stage being connected to the output of the end stage of said second shift register stages;

first means, connected to each of the outputs of said second shift register stages and to the output of said first shift register stage, for resetting all the outputs of said second shift register stages to "0" when the output of the first shift register stage is at "1"; and

second means, connected to each of the outputs of said second shift register stages and to the output of said first shift register stage, for setting the output of said first register stage at "1" when all the outputs of said second register stages are at "0".

# Fig. 1

| 2 | 1 | 3 | 4 | 5 |
|---|---|---|---|---|
| SHIFT REGISTER PORTION | WORD LINE DRIVER PORTION (FOR REFRESH) | MEMORY CELL ARRAY | WORD LINE DRIVER PORTION (FOR ACCESS) | NOR GATE PORTION |

WL

MC

BL

WDR

WDA

$A , \overline{A}$

# Fig. 2

$\phi_1$

$\phi_0$

21   22   23

$Q_{11}$   $Q_{12}$   $N_{12}$   $N_{21}$   $Q_{21}$   $Q_{22}$   $N_{22}$   $N_{31}$   $Q_{31}$   $Q_{32}$   $N_{32}$

$Q_{13}$   $Q_{23}$   $Q_{33}$

$C_{11}$   $C_{21}$   $C_{31}$

$V_{SS}$

## Fig. 3

| SHIFT REGISTER SETUP CIRCUIT | SHIFT REGISTER PORTION | WORD LINE DRIVER PORTION (FOR REFRESH) | | WORD LINE DRIVER PORTION (FOR ACCESS) | NOR GATE PORTION |

6  2  1  3  4  5

MEMORY CELL ARRAY

WL
MC
BL

WDR

WDA

A, Ā

## Fig. 4

6  2  1  3

SHIFT REGISTER SETUP CIRCUIT

| SR 511 | WD 511 | WL 511 |
| SR 510 | WD 510 | WL 510 |
| SR 002 | WD 002 | WL 002 |
| SR 001 | WD 001 | WL 001 |
| SR 000 | WD 000 | WL 000 |

Fig. 5